Europäisches Patentamt

European Patent Office

Office européen des brevets

(11) Publication number: **0 273 415**
**A2**

## EUROPEAN PATENT APPLICATION

(21) Application number: 87119228.2

(22) Date of filing: 24.12.87

(51) Int. Cl.⁴ **H05K 3/30** , C09J 3/14 , C08F 299/02

(30) Priority: **27.12.86 JP 314021/86**

(43) Date of publication of application:
**06.07.88 Bulletin 88/27**

(84) Designated Contracting States:
**DE GB**

(71) Applicant: **SOMAR CORPORATION**
**11-2, Ginza 4-chome Chuo-ku**
**Tokyo(JP)**

(72) Inventor: **Fujii, Ryuichi**
**33-8-10-206, Harayama 2-chome**
**Urawa-shi Saitama(JP)**
Inventor: **Nagase, Rihei**
**31-5, Sekibara 3-chome**
**Adachi-ku Tokyo(JP)**

(74) Representative: **Hansen, Bernd, Dr.rer.nat. et al·**
**Hoffmann, Eitle & Partner Patentanwälte**
**Arabellastrasse 4**
**D-8000 München 81(DE)**

(54) **Adhesive for surface mounting components.**

(57) In accordance with this invention, an adhesive for surface mounting components can be obtained by compounding a polymerizable prepolymer, a reactive diluent, and a polymerization initiator and in addition to these, a chelating agent and a polymerization inhibitor.

The adhesive of this invention is not only excellent in storage stability and adhesion strength but also fully satisfactory in the points of coating properties and heat curing speed from the practical standpoint and, hence, they are extremely useful as an adhesive for surface mounting components.

EP 0 273 415 A2

## ADHESIVE FOR SURFACE MOUNTING COMPONENTS

FIELD OF THE INVENTION

This invention relates to a photopolymerizable and heat polymerizable adhesive for surface mounting components (hereinafter "SMC"), which contains specified amounts of specified components.

The adhesive of this invention is used in the case where printed circuit boards are temporarily fitted with SMC such as, for example, chip resistors, chip capacitors, SOT's, flat-pack IC's, etc.

BACKGROUND OF THE INVENTION

Heretofore, in the case that printed circuit boards are temporarily fitted or mounted with so-called SMC such as chip resistors, chip capacitors, SOT's, flat-pack IC's, etc. having no lead-wire, use of an adhesive which is curable by both an ultraviolet light and a heat has been known. An adhesive of this sort is applied onto a printed circuit board by the screen printing method, a method using a dispenser apparatus, a method using a transfer pin, etc., and, after cautiously placing SMC on the printed curcuit board, an ultraviolet light is irradiated to cure the adhesive. In this case, even the adhesive portions that have not been irradiated with an ultraviolet light, such as the adhesive underlying the SMC, can also be completely cured either by a heat which is subsidiarily generated at the time of irradiation of an ultraviolet light or by combined use of a curing furnace separately installed.

In such a prior art technique, ultraviolet light-curable adhesives which are endowed with heat curing properties by the addition of a heat polymerization initiator such as organic peroxides have been used.

However, adhesives which have hitherto been known have a number of defects in storage stability, coating properties, heat curing speed, adhesion strength, etc. That is, if the heat curing speed is increased, not only the storage stability becomes poor, but also the viscosity of the adhesive remarkably rises which results in adversely affecting the coating properties. On the other hand, if the storage stability is improved, although the coating properties are improved, the heat curing speed becomes so slow that the adhesion strength can no longer be sufficient. Therefore, none of the conventional adhesives can satisfy all of the storage stability, coating properties, heat curing speed, and adhesion strength simultaneously.

SUMMARY OF THE INVENTION

An object of this invention is to provide an adhesive which can fully satisfy all of the storage stability, coating properties, heat curing speed, and adhesion strength simultaneously from the practical standpoint while overcoming the above described defects.

In order to achieve this object, the present inventors have made extensive investigations on adhesives which comprise a polymerizable prepolymer, a reactive diluent, and a polymerization initiator as components. As the result, they have found that combined use of specific amounts of a chelating agent and a polymerization inhibitor is extremely useful for achievement of the above-described object and attained this invention.

DETAILED DESCRIPTION OF THE INVENTION

The chelating agent which can be used in this invention includes aminocarboxylic acids. Specific examples include iminodiacetic acid, N-methyliminodiacetic acid, nitrilotriacetic acid, ethylenediamine-N,N'-diacetic acid, ethylenediamine-N,N,N',N'-tetraacetic acid, N-hydroxyethylethylenediamine-N,N,N'-triacetic acid, N-dihydroxyethylglycine, ethylenebis(hydroxyphenylglycine), and sodium salts thereof. Among them, N-hydroxyethylethylenediamine-N,N,N'-triacetic acid is especially preferable because it gives rise to an outstandingly excellent effect.

As the polymerization inhibitor which can be used, there can be used usual heat polymerization inhibitors such a phenol derivatives or aromatic amine derivatives. Specific examples include hydroquinone, hydroquinonemonomethyl ether, catechol, 2,6-di-t-butyl-4-methylphenyl, phenothiazine, cupferron, etc.

Examples of the polymerizable prepolymer which can be used in this invention include unsaturated polyesters, epoxy (meth)acrylates, urethane (meth)acrylates, oligoester (meth)acrylates, etc.

The above-described unsaturated polyesters are polyesters having a molecular weight from 1,000 to 10,000 and containing therein ethylenically unsaturated bonds and are commercially available under the trade names of, for example, Upica® 8554 (made by Nippon Upica Co., Ltd.) and New Track® 410 S (made by Kao Corporation).

The above-described epoxy (meth)acrylates are products obtained by esterifying epoxy resins having bisphenol-A, phenol or cresol novolak as a skeleton with (meth)acrylic acid and are commercially available under the trade names of, for example, Ripoxy® SP-1509 and SP-4010 (made by Showa Highpolymer Co., Ltd).

The above-described urethane (meth)acrylates are generally obtained by reacting a diol such as aliphatic diols (e.g., ethylene glycol, etc.), ether diols having two hydroxyl groups at the ether chain terminal ends, and ester diols having two hydroxyl groups at the ester chain terminal ends with a stoichiometric excess of a diisocyanate such as toluene diisocyanate, isophorone diisocyanate, etc. to form a urethane compound having isocyanato groups at the terminal ends which is then further reacted with a hydroxyalkyl (meth)acrylate. Commercial products are available under the trade names of, for example Uvithane® 893 (made by Thiochol Chemical Corp.) and U-6HA (made in Shin Nakamura Kagaku Kogyo Co., Ltd).

The above-described oligoester (meth)acrylates are polyfunctional (meth)acrylates having, as a skeleton, an ester compound obtained from aromatic carboxylic acids and are commercially available under the trade names of, for example, Aronix® M-8060 and M-7100 (made by Toagosei Chemical Industry Co., Ltd.).

Examples of the reactive diluent which can be used in this invention include diglycidyl ester di(meth)-acrylates of dibasic fatty acids containing 4 or more carbon atoms. They can be prepared by adding two molecules of (meth)acrylic acid to a diglycidyl ester of a dibasic fatty acid containing 4 or more carbon atoms. Preferred examples of the dibasic fatty acid include saturated acids such as succinic acid, glutaric acid, adipic acid, dimethyladipic acid, suberic acid, ethylpropylglutaric acid, brassylic acid (undecanedicarboxylic acid), etc. and unsaturated acids such as heptenoic diacid, dimethyloctenoic diacid, undecenoic diacid, pentadecadienoic diacid, etc. Among them, saturated acids or unsaturated acids containing from about 10 to 30 carbon atoms are most preferable. Though the dibasic acids of this sort can be used singly, they are used to advantage in admixture thereof. Examples of such an admixture include a mixture of fatty acids obtained by reacting a Fenton's reagent with cyclohexanone, which is commercially available.

Further, as other reactive diluents, there can be mentioned monofunctional monomers containing therein one ethylenically unsaturated bond, such as 2-hydroxyethyl (meth)acrylate, tetrahydrofurfuryl (meth)-acrylate, dicyclopentenyl (meth)acrylate, etc., and polyfunctional monomers containing therein a plurality of ethylenically unsaturated bonds, such as 1,6-hexanediol di(meth)acrylate, trimethylpropane tri(meth)acrylate, dipentaerythritol hexa(meth)acrylate, etc.

The polymerization initiator as referred to herein includes both a photopolymerization initiator and a heat polymerization initiator. Examples of the photopolymerization initiator are preferably compounds containing therin a benzoyl moiety, such as benzoin, benzoin methyl ether, benzoin isopropyl ether, benzophenone, acetophenone, 2-hydroxy-2-methylpropiophenone, anthraquinone, 2-ethylanthraquinone, 2-chlorothioxanthone, hydroxycyclohexyl phenyl ketone, benzyldimethylketal, etc.

As the heat polymerization initiator, usual ordinary organic peroxides can be used. Specific example include ketone peroxides such as methyl ethyl ketone peroxide, cyclohexanone peroxide, etc.; diacyl peroxides such as acetyl peroxide, benzoyl peroxide, etc.; hydro peroxides such as t-butyl hydroperoxide, cumene hydroperoxide, etc.; dialkyl peroxides such as di-t-butyl peroxide, dicumyl peroxide, etc.; alkyl peresters such as t-butyl peracetate, t-butyl perbenzoate, etc.; peroxycarbonates such as diisopropyl peroxydicarbonate, bis(4-t-butylcyclohexyl) peroxydicarbonate, etc.; and peroxyketals such as 1,1-bis(t-butylperoxy)-3,3,5-trimethylcyclohexane, 1,1-bis(t-butylperoxy)cyclohexane, etc.

Next, the amounts of the respective components to be added in this invention will be described.

Firstly, the chelating agent is preferably used in an amount ranging from 0.002 to 2 parts by weight based on 100 parts by weight of the polymerizable prepolymer (referred to hereinafter as component (A)). This is because if the amount of the chelating agent is less than 0.002 part by weight, the composition becomes unstable to storage, whereas if it exceeds 2 parts by weight, the curing cannot be satisfactory, which shows insufficient adhesion strength.

The diglycidyl ester di(meth)acrylate of a dibasic acid containing 4 or more carbon atoms (referred to hereinafter as component (B)) as the reactive diluent is used in an amount of from 30 to 150 parts by weight based on 100 parts by weight of the component (A). When the amount of the component (B) is less than 30 parts by weight, the adhesion decreases, whereas when exceeding 150 parts by weight, the hardness of the cured product remarkably lowers.

3

On the other hand, the monofunctional or polyfunctional monomer (referred to hereinafter as component (C)) as other reactive diluent is used in an amount of from 20 to 250 parts by weight based on 100 parts by weight of the component (A). When the amount of the component (C) is less than 20 parts by weight, the effect of diluting the component (A) cannot be fully exhibited, so that the viscosity of the composition becomes excessively high to make the operation difficult. On the contrary, when the amount of the component (C) exceeds 250 parts by weight, the ultraviolet light-curing properties are impaired by the occurrence of excessive dilution.

The amount of the photopolymerization initiator as the polymerization initiator is from 0.2 to 20 parts by weight based on 100 parts by weight of the sum of the polymerizable prepolymer and the reactive diluent. When it is less than 0.2 part by weight, the photocuring speed becomes low, and moreover, moisture resistance, mechanical properties, etc. of the cured product become deteriorated, whereas when it exceeds 20 parts by weight, the cured product of a resin having a high molecular weight cannot be obtained and, at the same time, moisture resistance remarkably lowers. In either case, the product can hardly be put into practical use.

The amount of the heat polymerization initiator used is from 0.2 to 20 parts by weight based on 100 parts by weight of the sum of the polymerizable prepolymer and the reactive diluent. When it is less than 0.2 part by weight, the heat curing speed becomes low, and moreover, moisture resistance, mechanical properties, etc. of the cured product become deteriorated, whereas when it exceeds 20 parts by weight, the cured product of a resin having a high molecular weight cannot be obtained and, at the same time, moisture resistance remarkably lowers. In either case, the product can hardly be put into practical use.

The amount of the heat polymerization inhibitor used is from 0.002 to 2 parts by weight based on 100 parts by weight of the component (A). This is because if too small, the composition becomes unstable to storage, while if too large, the adhesion strength becomes insufficient.

The composition of this invention can, if desired, contain other additives as shown below.

[Curing Accelerator] Metallic salts of long-chain organic acids (metallic soaps), such as cobalt naphthenate, cobalt octenoate, manganese naphthenate, manganese octenoate, etc.; and amines or quaternary ammonium salts, such as dimethylaniline, N-phenylmorpholine, trimethylbenzylammonium chloride; etc.

[Inorganic Filler] Powders of talc, fused silica, aluminum hydroxide, etc.

[Coloring Agent] Organic pigments, inorganic pigments, dyes, etc.

[Thixotropic Agent] Ultrafine silica, etc.

Any of the above-described additives is commonly used in the art, and they are suitably used in suitable amounts in accordance with the use purposes.

The adhesive of this invention is not only excellent in storage stability and adhesion strength but also fully satisfactory in the points of coating properties and heat curing speed from the practical standpoint and, hence, they are extremely useful as an adhesive for SMC.


## EXAMPLE 1

Adhesives were prepared by compounding the following components (a) to (g) and a filler in the amounts indicated in TABLE 1 as later described.

Component (a): Unsaturated polyester having a molecular weight of about 2,500 (prepolymer) [manufactured by Nippon Upica Co., Ltd., Upica® 8554]

Component (b): Diglycidyl ester diacrylate of a dibasic unsaturated fatty acid containing from 16 to 20 carbon atoms [manufactured by Okamura Seiyu Co., Ltd.; ULB 20GA]

Component (c): Ethylene oxide-modified dicyclopentenyl methacrylate [manufactured by Rohm & Haas Co.; QM 657]

Component (d): Benzoin isopropyl ether

Component (e): t-Butyl perbenzoate

Component (f): Hydroquinonemonomethyl ether

Component (g): Ethylenediamine-N,N,N',N'-tetraacetic acid

Filler: Talc of 3 microns in average particle diameter

With respect to the adhesives prepared, the storage stability and adhesion strength were measured with the results being shown in TABLE 1 as later described. The methods of measurement employed are as follows.

[Storage Stability]

100 g of the adhesive was placed in a light-shaded 100-ml polypropylene vessel and stored at 30°C. There was investigated the number of days elapsed before the gelation occurred.

[Adhesion Strength]

0.8 mg of the adhesive was applied onto a printed circuit board and, after an SOT (1.5 mm x 2.9 mm) was mounted in the central part thereof, the assembly was irradiated with an ultraviolet light for 20 seconds at a distance of 20 cm from a high-pressure mercury vapor lamp having a power input of 80 W/cm. Immediately thereafter, the assembly was heated for 10 minutes in an atmosphere at 150°C. Then, the shear adhesion strength per chip (kg/SMC) was measured at room temperature. The SOT is pushed in the direction rectangular to the longitudinal axis of the SOT with a push-pull-gauge. Then, the shear force in kg is measured each of ten times, among which the smallest shear force has to exceed the specified value of 2.0 kg.

EXAMPLES 2 AND 3 AND COMPARATIVE EXAMPLES 1 TO 3

Adhesives were respectively prepared in the same manner as in EXAMPLE 1 by the formulations indicated in TABLE 1 as later described.

With respect to the adhesives prepared, the same measurements were made as in EXAMPLE 1, with the results being shown in TABLE 1.

TABLE 1

| Composition | EXAMPLE NO. | | | COMPARATIVE EXAMPLE NO. | | |
|---|---|---|---|---|---|---|
| | 1 | 2 | 3 | 1 | 2 | 3 |
| Component (a) | 100 | 100 | 100 | 100 | 100 | 100 |
| Component (b) | 80 | 80 | 80 | 80 | 80 | 80 |
| Component (c) | 120 | 120 | 120 | 120 | 120 | 120 |
| Component (d) | 9 | 9 | 9 | 9 | 9 | 9 |
| Component (e) | 6 | 6 | 6 | 6 | 6 | 6 |
| Component (f) | 0.2 | 0.5 | 0.1 | 3 | – | 0.5 |
| Component (g) | 0.2 | 0.1 | 0.5 | – | 3 | – |
| Filler | 200 | 200 | 200 | 200 | 200 | 200 |
| Physical Properties | | | | | | |
| Storage Stability | ≧60 days | ≧60 days | ≧60 days | 20 days | 15 days | 4 days |
| Adhesion Strength (kg/SMC) | 5.5 | 5.3 | 5.6 | 3.0 | 3.5 | 5.5 |

(Note) The units of numerical values concerning the components and the agent are parts by weight.

While the invention has been described in detail and with reference to specific embodiments thereof, it will be apparent to one skilled in the art that various changes and modifications can be made therein without departing from the spirit and scope thereof.

**Claims**

1. An adhesive for surface mounting components comprising a polymerizable prepolymer, a reactive diluent, and a polymerization initiator, said adhesive further comprising a chelating agent and a polymerization inhibitor.

2. An adhesive as in claim 1, wherein said chelating agent is N-hydroxyethylethylenediamine-N,N,N'-triacetic acid or sodium salts thereof.

3. An adhesive as in claim 1, wherein said chelating agent is ethylenediamine-N,N,N',N'-tetraacetic acid or sodium salts thereof.

4. An adhesive as in claim 1, wherein said chelating agent is used in an amount of from 0.002 to 2 parts by weight based on 100 parts by weight of said polymerizable prepolymer.

5. An adhesive as in claim 1, wherein said polymerization inhibitor is hydroquinonemonomethyl ether.

6. An adhesive as in claim 1, wherein said polymerization inhibitor is cupferron.

7. An adhesive as in claim 1, wherein said polymerization inhibitor is used in an amount of from 0.002 to 2 parts by weight based on 100 parts by weight of said polymerizable prepolymer.